# EUROPEAN PATENT SPECIFICATION

(11) **EP 4 258 369 B1**
(45) Date of publication and mention of the grant of the patent: **08.07.2026**
(21) Application number: 23165546.5
(22) Date of filing: 30.03.2023
(51) Int. Cl.: H10H 20/856, H10H 20/851, H10H 20/858

(54) **OPTICAL MEMBER AND LIGHT-EMITTING DEVICE**
OPTISCHES ELEMENT UND LICHTEMITTIERENDE VORRICHTUNG
ÉLÉMENT OPTIQUE ET DISPOSITIF ÉLECTROLUMINESCENT

(30) Priority: 31.03.2022 JP 2022059393
(43) Date of publication of application: 11.10.2023
(73) Proprietor: Nichia Corporation, Anan-shi, Tokushima 774-8601 (JP)
(72) Inventor: KUSUSE, Takeshi, Anan-shi, 774-8601 (JP)
(74) Representative: Vossius & Partner Patentanwälte Rechtsanwälte mbB

(56) References cited:
- EP-A1- 3 012 523
- EP-A1- 3 012 878
- EP-A1- 3 147 955

## Description

### CROSS-REFERENCE TO RELATED APPLICATION

This application claims priority to Japanese Patent Application No. 2022-059393, filed on March 31, 2022.

### BACKGROUND

The present disclosure relates to an optical member and a light-emitting device.

An optical member is known that includes a wavelength conversion member and a surrounding portion supporting the wavelength conversion member (for example, see Japanese Unexamined Patent Application Publication No. 2019-176076).

EP 3 012 878 A1 relates to a method of manufacturing a light emitting device.

EP 3 147 955 A1 relates to a wavelength conversion member and a light emitting device using the wavelength conversion member.

EP 3 012 523 A1 relates to a wavelength conversion member, light source and vehicle headlamp.

### SUMMARY

The invention is specified by the independent claims. Preferred embodiments are defined in the dependent claims. In the following description, although numerous features may be designated as optional, it is nevertheless acknowledged that all features comprised in the independent claims are not to be read as optional. An object of the present disclosure is to provide an optical member that exhibits good heat dissipation performance.

An optical member according to the present invention has a first surface, a second surface opposite to the first surface, and a lateral surface between the first surface and the second surface. The optical member includes a reflective member containing a light-reflective material and an inorganic binder, wherein the inorganic binder contains silica and an alkali metal, a wavelength conversion member disposed in the reflective member, and a heat dissipation member disposed in the reflective member apart from the wavelength conversion member.

The optical member of the present disclosure exhibits good heat dissipation performance.

### BRIEF DESCRIPTION OF THE DRAWINGS

FIG. 1 is a schematic perspective view of an exemplary optical member according to a first embodiment according to the present disclosure.
FIG. 2 is a schematic cross-sectional view taken along the line II-II of FIG. 1.
FIG. 3 is a schematic enlarged cross-sectional view of a portion of a reflective member included in the exemplary optical member according to the first embodiment.
FIG. 4 is a schematic cross-sectional view of an optical member according to Modified Example 1 of the first embodiment.
FIG. 5 is a schematic cross-sectional view of an optical member according to Modified Example 2 of the first embodiment.
FIG. 6 is a schematic bottom view of an optical member according to Modified Example 3 of the first embodiment.
FIG. 7 is a schematic bottom view of an optical member according to Modified Example 4 of the first embodiment.
FIG. 8 is a schematic bottom view of an optical member according to Modified Example 5 of the first embodiment.
FIG. 9 is a schematic bottom view of an optical member according to Modified Example 6 of the first embodiment.
FIG. 10 is a schematic bottom view of an optical member according to Modified Example 7 of the first embodiment.
FIG. 11 is a schematic bottom view of an optical member according to Modified Example 8 of the first embodiment.
FIG. 12 is a schematic bottom view of an optical member according to Modified Example 9 of the first embodiment.
FIG. 13 is a schematic bottom view of an optical member according to Modified Example 10 of the first embodiment.
FIG. 14 is a schematic bottom view of an exemplary optical member according to a second embodiment of the present disclosure.
FIG. 15 is a schematic cross-sectional view taken along the line XV-XV of FIG. 14.
FIG. 16 is a schematic plan view of an exemplary light-emitting device according to a third embodiment of the present disclosure.
FIG. 17 is a schematic cross-sectional view of the exemplary light-emitting device according to the third embodiment.
FIG. 18 is a schematic plan view of an exemplary light-emitting device according to a fourth embodiment of the present disclosure.
FIG. 19 is a schematic cross-sectional view of the exemplary light-emitting device according to the fourth embodiment.

### DETAILED DESCRIPTION OF EMBODIMENTS

Certain embodiments for carrying out the invention according to the present disclosure will be described below with reference to the accompanying drawings. Optical members and light-emitting devices described below are intended to embody the technical idea of the invention according to the present disclosure. The invention according to the present disclosure is not limited to the embodiments below unless specifically stated otherwise. In the drawings, members having the same function may be denoted by the same reference numeral. For convenience and ease of explanation or understanding of the main points, the description below may be made for each embodiment, but the configurations of different embodiments can be partially replaced or combined. In the subsequent embodiments, description of matters in common with the preceding embodiments will be omitted, and only different points will be described. In particular, similar actions and effects provided by similar configurations are not mentioned for every embodiment. The sizes, positional relationships, and the like of members shown in the drawings may be exaggerated for clarity of descriptions. In some cases, a cross-sectional end view showing only the cut surface of a member is used for a cross-sectional view.

### First Embodiment

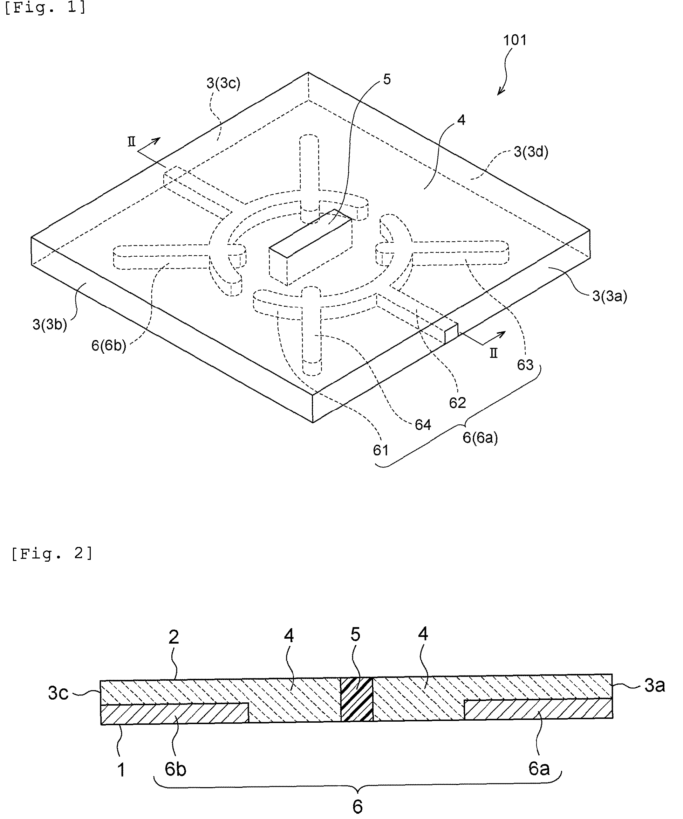

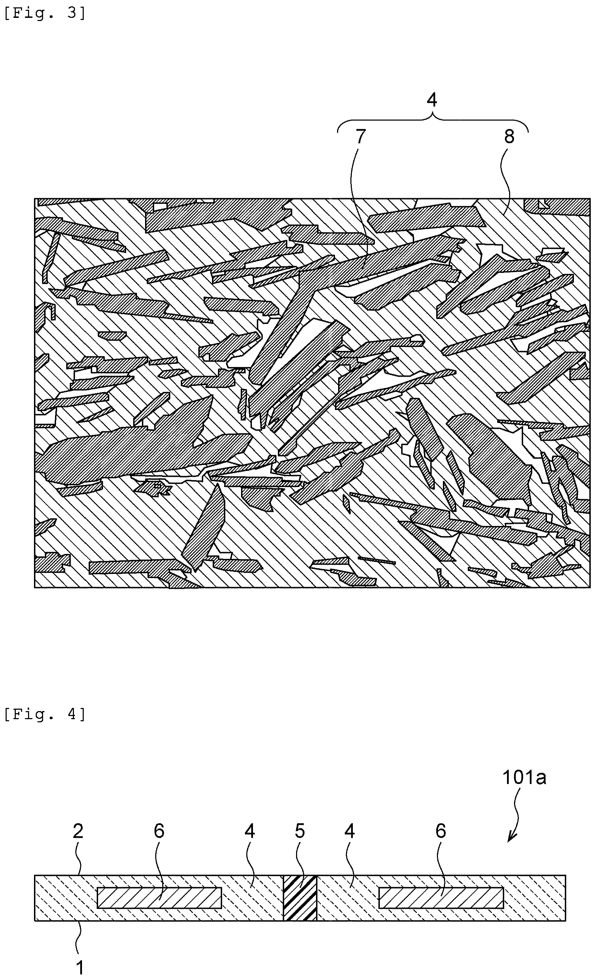

A first embodiment of the present disclosure relates to an optical member 101. The optical member 101 according to the first embodiment of the present disclosure is described referring to FIG. 1, FIG. 2, and FIG. 3. FIG. 1 is a schematic perspective view of the optical member 101. FIG. 2 is a schematic cross-sectional view of the optical member 101. The schematic cross-sectional view of FIG. 2 shows a cross section of the optical member 101 cut along the line II-II of FIG. 1 in the height direction. FIG. 3 is a schematic enlarged cross-sectional view of a portion of a reflective member 4 included in the optical member 101. As for the optical member 101, a second surface 2 side is regarded as the upper side, and a first surface 1 side is regarded as the lower side. That is, the upper side of FIG. 2 is regarded as the upper side, and the lower side is regarded as the lower side.

As shown in FIG. 1, FIG. 2, or FIG. 3, the optical member 101 of the present disclosure has:
a first surface 1, a second surface 2 opposite to the first surface 1, and lateral surfaces 3 between the first surface 1 and the second surface 2 and includes:
the reflective member 4 containing a light-reflective material 7 and an inorganic binder 8;
a wavelength conversion member 5 disposed in the reflective member 4; and
heat dissipation members 6 disposed in the reflective member 4 apart from the wavelength conversion member 5. The lateral surfaces 3 include a first lateral surface 3a, a second lateral surface 3b, a third lateral surface 3c, and a fourth lateral surface 3d. The heat dissipation members 6 include a first heat dissipation member 6a and a second heat dissipation member 6b.

The first surface 1 of the optical member 101 according to the first embodiment of the present disclosure includes a surface (lower surface) of the reflective member 4, a surface (lower surface) of the wavelength conversion member 5, and surfaces (lower surfaces) of the heat dissipation members 6. The second surface 2 includes a surface (upper surface) of the reflective member 4 and a surface (upper surface) of the wavelength conversion member 5. Each of the first lateral surface 3a and the third lateral surface 3c includes a surface (lateral surface) of the reflective member 4 and a surface (lateral surface) of the corresponding heat dissipation member 6. Each of the second lateral surface 3b and the fourth lateral surface 3d includes a surface (lateral surface) of the reflective member 4.

In the optical member 101, the heat dissipation members 6 are disposed in the reflective member 4. Accordingly, heat generated in the wavelength conversion member 5 can be effectively dissipated. Further, the heat dissipation members 6 can function as rib members that support the reflective member 4 to allow the optical member 101 to have the improved strength.

### Wavelength Conversion Member

The wavelength conversion member 5 is disposed in the reflective member 4. The wavelength conversion member 5 constitutes a portion of the first surface 1 and a portion of the second surface 2 of the optical member 101. Specifically, the wavelength conversion member 5 constitutes the first surface 1 of the optical member 101 together with the reflective member 4 and the heat dissipation members 6. The wavelength conversion member 5 also constitutes the second surface 2 of the optical member 101 together with the reflective member 4. In other words, the wavelength conversion member 5 is supported by the reflective member 4, and the upper surface and the lower surface of the wavelength conversion member 5 are exposed from the reflective member 4. The wavelength conversion member 5 may be disposed in the reflective member 4 such that portions having the upper surface and the lower surface protrude from the reflective member 4. The wavelength conversion member 5 is located in the central portion of the reflective member 4 in a plan view.

In the optical member 101, the wavelength conversion member 5 is a quadrangular prism having elongated rectangular upper and lower surfaces. The shape of the wavelength conversion member 5 is not limited to the above but may be, for example, a regular quadrangular prism or a circular cylinder.

The wavelength conversion member 5 can be a member containing a phosphor, preferably a member in which a phosphor has been dispersed in a resin.

The phosphor may be a red phosphor. Red phosphors generate much heat at the time of wavelength conversion, and therefore high heat dissipating characteristics of the optical member 101 of the present disclosure is more beneficial when a red phosphor is used.

Examples of the phosphor that can be used include yttrium-aluminum-garnet based phosphors (such as Y₃(Al,Ga)₅O₁₂:Ce); lutetium-aluminum-garnet based phosphors (such as Lu₃(Al,Ga)₅O₁₂:Ce); terbium-aluminum-garnet based phosphors (such as Tb₃(Al,Ga)₅O₁₂:Ce); CCA based phosphors (such as Ca₁₀(PO₄)₆Cl₂:Eu); SAE based phosphors (such as Sr₄Al₁₄O₂₅:Eu); chlorosilicate based phosphors (such as Ca₈MgSi₄O₁₆Cl₂:Eu); oxynitride based phosphors such as β-SiAlON based phosphors (such as (Si,Al)₃(O,N)₄:Eu) and α-SiAlON based phosphors (such as Ca(Si,Al)₁₂(O,N)₁₆:Eu); nitride based phosphors such as SLA based phosphors (such as SrLiAl₃N₄:Eu), CASN based phosphors (such as CaAlSiN₃:Eu), and SCASN based phosphors (such as (Sr,Ca)AlSiN₃:Eu); fluoride based phosphors such as KSF based phosphors (such as K₂SiF₆:Mn), KSAF based phosphors (such as K₂Si_{0.99}Al_{0.01}F_{5.99}:Mn), and MGF based phosphors (such as 3.5MgO·0.5MgF₂·GeO₂:Mn); phosphors having the perovskite structure (such as CsPb(F,CI,Br,I)₃), and quantum-dot phosphors (such as CdSe, InP, AgInS₂, and AgInSe₂). For the phosphor added to the wavelength conversion member, a single type of phosphor or a plurality of types of phosphors may be used.

The KSAF based phosphor may have the composition represented by a formula (I) below.

M₂[SiₚAl_{q}MnᵣFₛ] (I)

In the formula (I), M represents an alkali metal and may include at least K. Mn may be a tetravalent Mn ion. p, q, r, and s may satisfy the relationships 0.9 ≤ p + q + r ≤ 1.1, 0 < q ≤ 0.1, 0 ≤ r ≤ 0.2, and 5.9 ≤ s ≤ 6.1. The relationships 0.95 ≤ p + q + r ≤ 1.05 or 0.97 ≤ p + q + r ≤ 1.03; 0 ≤ q ≤ 0.03, 0.002 ≤ q ≤ 0.02, or 0.003 ≤ q ≤ 0.015; 0.005 ≤ r ≤ 0.15, 0.01 ≤ r ≤ 0.12, or 0.015 ≤ r ≤ 0.1; and 5.92 ≤ s ≤ 6.05 or 5.95 ≤ s ≤ 6.025 may be preferably satisfied. Examples of the composition include K₂[Si_{0.946}Al_{0.005}Mn_{0.049}F_{5.995}], K₂[Si_{0.9042}Al_{0.008}Mn_{0.050}F_{5.992}], and K₂[Si_{0.939}Al_{0.014}Mn_{0.047}F_{5.986}]. Such a KSAF based phosphor can provide red emission having a high luminance and a narrow half width of an emission peak.

The optical member 101 can provide light with a desired emission color by combining the wavelength conversion member 5 and an appropriate light-emitting element. For example, a light-emitting element that can emit blue light and a wavelength conversion member 5 containing a phosphor that can emit yellow light are combined to provide white light. A light-emitting element that can emit blue light and a wavelength conversion member 5 containing a phosphor that can emit red light (hereinafter referred to as a red phosphor) and a phosphor that can emit green light (hereinafter referred to as a green phosphor) may be combined.

Preferable examples of the yellow phosphor used in the wavelength conversion member 5 include the yttrium-aluminum-garnet based phosphors described above. Preferable examples of the green phosphor used in the wavelength conversion member 5 include phosphors having narrow half widths of emission peaks, such as the phosphors having the perovskite structure or quantum-dot phosphors described above. Preferable examples of the red phosphor used in the wavelength conversion member 5 include, similarly to the green phosphor, phosphors having narrow half widths of emission peaks, such as the KSF based phosphors, the KSAF based phosphors, and the quantum-dot phosphors described above.

The resin used in the wavelength conversion member 5 may be, for example, a resin selected from silicone resins, modified silicone resins, epoxy resins, phenolic resins, polycarbonate resins, acrylic resins, methylpentene resins, and polynorbornene resins. The wavelength conversion member 5 may employ, for example, an inorganic material such as glass instead of these resins.

The wavelength conversion member 5 may be, for example, a phosphor ceramic in which at least one type of phosphor has been sintered.

The wavelength conversion member 5 may be a layered body in which a plurality of layers containing at least one type of phosphor have been layered. For example, the wavelength conversion member 5 may be a layered body in which a plurality of resin layers containing a phosphor have been layered, a layered body in which a plurality of phosphor ceramic layers have been layered, or a layered body in which a resin layer containing a phosphor and a phosphor ceramic layer have been layered.

### Reflective Member

The wavelength conversion member 5 and the heat dissipation members 6 are disposed in the reflective member 4. In other words, the reflective member 4 supports the wavelength conversion member 5 and the heat dissipation members 6. The reflective member 4 constitutes a portion of the first surface 1, a portion of the second surface 2, and a portion of the lateral surface 3 of the optical member 101. Specifically, the reflective member 4 constitutes the first surface 1 of the optical member 101 together with the wavelength conversion member 5 and the heat dissipation members 6. The reflective member 4 constitutes the second surface 2 together with the wavelength conversion member 5. The reflective member 4 also constitutes the second lateral surface 3b and the fourth lateral surface 3d. The reflective member 4 constitutes the first lateral surface 3a and the third lateral surface 3c together with the heat dissipation members 6.

In the optical member 101, the reflective member 4 is a plate-shaped member and has a substantially square outer shape in a plan view. The shape of the reflective member 4 is not limited to the above and may be, for example, an elongated rectangular or circular outer shape in a plan view.

The coefficient of linear thermal expansion of the reflective member 4 is preferably 0.5 ppm/°C or more and 5 ppm/°C or less in the temperature range of 40°C to 300°C. The expansion of the reflective member 4 can therefore be suppressed, and the reliability can be improved, even when the temperature of the reflective member 4 has risen in the use of the optical member 101.

The reflective member 4 contains the light-reflective material 7 and the inorganic binder 8.

The reflective member 4 can be formed by, for example, mixing the light-reflective material 7, silica powder, and an alkaline solution and then subjecting the resulting mixture to a heating step.

### Light-reflective Material

The light-reflective material 7 is powder of an inorganic material.

The inorganic material is preferably boron nitride or alumina. A high reflectance can be obtained by using boron nitride or alumina.

The light-reflective material 7 can be preferably plate-shaped or flake-shaped particles.

The powder of the light-reflective material 7 may be primary particles or secondary particles obtained by aggregation of two or more primary particles. Alternatively, primary particles and secondary particles may coexist.

The average aspect ratio of the light-reflective material 7 is 10 or more, preferably 10 or more and 70 or less. The average aspect ratio of the light-reflective material 7 is calculated by the following method.

### Method of Calculating Average Aspect Ratio

The average aspect ratio of the light-reflective material 7 is calculated by measuring the thickness and the width of the light-reflective material 7 in a cross-section of the reflective member 4.

A cross-section of the reflective member 4 is first exposed. The cross-section is exposed by cutting the reflective member 4.

Subsequently, the exposed cross-section is mirror-finished. The mirror-finished cross-section is photographed with a scanning electron microscope (SEM), the cross-section of the light-reflective material 7 is extracted, and a measurement region including the cross-sections of about 1,000 particles of the light-reflective material 7 is selected. The number of pixels of the microscope is set to about 20,000,000, and the magnification is set to 500 to 3,000. In the present specification, the cross-section of the light-reflective material 7 is a surface substantially perpendicular to at least one main surface of the light-reflective material 7. Plate-shaped particles of the light-reflective material 7 tend to overlap one another such that the main surfaces face each other in the inorganic binder 8 because of the shape. Accordingly, by appropriately selecting the cross-section to be exposed, the cross-section of the light-reflective material 7 can be extracted as appropriate using the SEM.

Subsequently, using image analysis software, the width (length of the cross-section of the light-reflective material 7 in the longitudinal direction) and the thickness (length of the cross-section of the light-reflective material 7 in the short direction) of each extracted cross-section of the light-reflective material 7 are each measured at one point, and the average value of the width relative to the thickness is calculated. The average value of the measured values of 100 particles of the light-reflective material 7 is defined as the average aspect ratio.

In the case in which the light-reflective material 7 is boron nitride, the average aspect ratio of the light-reflective material 7 is, for example, 16.5 or more and 19.2 or less. In the case in which the light-reflective material 7 is alumina, the average aspect ratio of the light-reflective material 7 is, for example, 10 or more and 70 or less.

The average particle diameter of the light-reflective material 7 is 0.6 µm or more and 43 µm or less.

The reflective member 4 may be manufactured through a heating step, and fusing of the powder of the light-reflective material 7 with the powder of the inorganic binder 8 by the heating step and elution of the powder of the light-reflective material 7 into another material, such as the alkaline solution, by the heating step are little. Accordingly, the shape and dimensions of the powder of the light-reflective material 7 are substantially the same as the shape and dimensions of the light-reflective material 7 contained in the reflective member 4 formed through the heating step. The average particle diameter of the light-reflective material 7 is therefore calculated by measuring the particle diameter of the powder of the light-reflective material 7 by the following method.

### Method of Calculating Average Particle Diameter

The particle diameter of the powder of the light-reflective material 7 is calculated, for example, using a scanning electron microscope "TM3030Plus" manufactured by Hitachi High-Tech Corporation.

First, one surface of double-sided tape made of carbon is put on the sample stage of the microscope, and the powder of the light-reflective material 7 is then disposed on the other surface of the double-sided tape. The number of pixels of the microscope is set to 1,230,000, the magnification is set to 1,000 to 2,000, and an image of 100 particles in the powder of the light-reflective material 7 is acquired. After that, the particle diameter of each particle is measured using image analysis software. In the present specification, the particle diameter of the powder of the light-reflective material 7 is the maximum diameter among diameters viewed from the main surface of the light-reflective material 7. Subsequently, the median diameter of the measured particle is calculated, and the calculated value is defined as the average particle diameter of the light-reflective material 7. Alternatively, the particle diameter of the powder of the light-reflective material 7 may be calculated by extracting the cross-section of the reflective member 4 with the SEM and measuring the particle diameter using image analysis software.

In the case in which the light-reflective material 7 is boron nitride, the average particle diameter of the light-reflective material 7 is, for example, 6 µm or more and 43 µm or less. In the case in which the light-reflective material 7 is alumina, the average particle diameter of the light-reflective material 7 is, for example, 0.6 µm or more and 10 µm or less.

### Inorganic Binder

The inorganic binder 8 supports the light-reflective material 7.

The inorganic binder 8 contains silica and an alkali metal Silica

The content ratio between silica and the light-reflective material 7 contained in the reflective member 4 is, for example, 1:4 or more and 1:1 or less in terms of weight ratio. That is, the weight of the light-reflective material 7 contained in the reflective member 4 is, for example, one or more and four or less times as large as the weight of silica contained in the reflective member 4. Within this range, shrinkage at the time of hardening of the mixture can be reduced. By setting the amount of the light-reflective material 7 to four times or less, decrease in hardenability can be suppressed. On the other hand, the amount of the light-reflective material 7 is once or more, shrinkage at the time of hardening is suppressed, and occurrence of cracks at the time of hardening can be prevented.

The average particle diameter of silica is, for example, 0.1 µm or more and 10 µm or less. Within this range, the density of the raw materials (light-reflective material 7 and silica) per volume can be enhanced, and the strength of the reflective member 4 can be secured.

The average particle diameter of the silica powder is preferably smaller than the average particle diameter of the light-reflective material 7. The silica powder can therefore fill gaps between particles of the light-reflective material 7 at the time of mixing. The average particle diameter of the silica powder is calculated by measuring the particle size distribution of the silica powder by laser diffraction. The average particle diameter of silica is a value measured before mixing with the alkaline solution. This is because the silica powder is dissolved when being mixed with the alkaline solution, which makes it difficult to determine the particle diameter from the reflective member 4. In order to calculate the content ratio between silica and the light-reflective material 7 from the reflective member 4, for example, the cross-section of the reflective member 4 extracted by the SEM may be observed to perform calculation based on the occupancy ratio between silica and the light-reflective material 7.

### Alkali Metal

The alkali metal is the alkali metal contained in the alkaline solution described above. The alkali metal is, for example, potassium or sodium.

The reflective member 4 preferably further contains a light-scattering material.

The light-scattering material can be preferably zirconia or titania.

In the case in which a light source emits ultraviolet light, zirconia, which absorbs less light in the ultraviolet wavelength range, is preferable. The reflective member 4 contains the light-scattering material, allowing for increasing the light reflectance by the reflective member 4.

In the case in which titania is used as the light-scattering material, titania alone may be used, or a material obtained by subjecting the surface of titania to various surface treatments with silica, alumina, zirconia, zinc, or an organic substance may be used.

In the case in which zirconia is used as the light-scattering material, zirconia alone may be used, or a material obtained by subjecting the surface of zirconia to various surface treatments with silica, alumina, zinc, or an organic substance may be used. Alternatively, stabilized zirconia to which calcium, magnesium, yttrium, or aluminum has been added or partially stabilized zirconia may be used.

In the case in which the light-scattering material is added to the reflective member 4, the light-scattering material exists in the inorganic binder 8 in a dispersed state.

The average particle diameter of the light-scattering material is preferably smaller than the average particle diameter of the light-reflective material 7. The light-scattering material is therefore disposed in gaps between particles of the light-reflective material 7, and light from the light source is inhibited from passing through the gaps between particles of the light-reflective material 7. The average particle diameter of the light-scattering material is measured by laser diffraction.

### Heat Dissipation Member

The heat dissipation members 6 are disposed in the reflective member 4 apart from the wavelength conversion member 5. The heat dissipation members 6 constitute a portion of the first surface 1, a portion of the first lateral surface 3a, and a portion of the third lateral surface 3c of the optical member 101. Specifically, the heat dissipation members 6 constitute the first surface 1 together with the reflective member 4 and the wavelength conversion member 5. The heat dissipation members 6 constitute the first lateral surface 3a and the third lateral surface 3c of the optical member 101 together with the reflective member 4. In other words, the heat dissipation members 6 are exposed from the reflective member 4 on the first surface 1, the first lateral surface 3a, and the third lateral surface 3c. The heat dissipation members 6 may be disposed in the reflective member 4 so as to partially protrude from the reflective member 4 on the first surface 1, the first lateral surface 3a, and the third lateral surface 3c.

In the optical member 101, the heat dissipation members 6 include a pair of heat dissipation members, specifically, the first heat dissipation member 6a and the second heat dissipation member 6b. The first heat dissipation member 6a and the second heat dissipation member 6b have the same shape, face each other across the wavelength conversion member 5, and, for example, are preferably disposed in a line-symmetrical manner about the central axis of the longitudinal direction of the wavelength conversion member 5 in a plan view.

Each of the first heat dissipation member 6a and the second heat dissipation member 6b includes a semicircular arc portion 61, a first bar portion 62, a second bar portion 63, and a third bar portion 64. The semicircular arc portion 61 is disposed to surround at least a portion of the wavelength conversion member 5. Specifically, the semicircular arc portion 61 is disposed to surround a long side of the wavelength conversion member 5 as viewed from the first surface side. The first bar portion 62, the second bar portion 63, and the third bar portion 64 are disposed substantially radially with respect to the wavelength conversion member 5 as viewed from the first surface. Specifically, the first bar portion 62 is connected to the central portion of the semicircular arc portion 61 and extends from the joint to the first lateral surface 3a as for the first heat dissipation member 6a or from the joint to the third lateral surface 3c as for the second heat dissipation member 6b. The second bar portion 63 and the third bar portion 64 are connected to the semicircular arc portion 61 between the joint between the first bar portion 62 and the semicircular arc portion 61 and the respective ends of the semicircular arc portion 61. The second bar portion 63 and the third bar portion 64 extend from the joints with the semicircular arc portion 61 to the corners of the reflective member 4. Further, the second bar portion 63 and the third bar portion 64 also extend inside the semicircular arc portion 61.

In the optical member 101 of the first embodiment, the semicircular arc portions 61 are disposed to surround the wavelength conversion member 5 and can efficiently receive heat generated in the wavelength conversion member 5. In particular, the second bar portions 63 and the third bar portions 64 extend inside the semicircular arc portions 61, and therefore heat generated in the wavelength conversion member 5 can be more efficiently received. The first bar portions 62, the second bar portions 63, and the third bar portions 64 are disposed substantially radially with respect to the wavelength conversion member 5 and can therefore diffuse heat received by the semicircular arc portion 61 toward the outer edges of the reflective member 4. Further, the heat dissipation members 6 are exposed from the first surface 1, the first lateral surface 3a, and the third lateral surface 3c and can therefore efficiently emit heat generated in the wavelength conversion member 5 to the outside.

The reflective member 4 is an inorganic material, and the adhesiveness to a bonding member such as solder (such as Au-Sn and Au-In) can be low. In the optical member 101 of the first embodiment, the heat dissipation members 6 are exposed from the first surface 1, so that the heat dissipation members 6 having high adhesiveness to the bonding member can be used as bonding portions. Accordingly, the optical member 101 in which the heat dissipation members 6 are exposed from the first surface 1 is easily bonded to another member, and the bonding strength is enhanced.

The heat dissipation members 6 are preferably metal members. The heat dissipation performance is enhanced by using metal members as the heat dissipation members 6. The bonding strength to the bonding member is also enhanced.

The metal in the metal members can be preferably Cu, Ag, Pt, Ni, Al, Pd, Au, Fe, Co, W, Mo, or an alloy of these metals.

The optical member 101 of the first embodiment can be modified in various ways as described below.

### Modified Example 1

FIG. 4 is a schematic cross-sectional view of an optical member 101a of Modified Example 1. As shown in FIG. 4, the heat dissipation members 6 are embedded in the reflective member 4 in the optical member 101a of Modified Example 1.

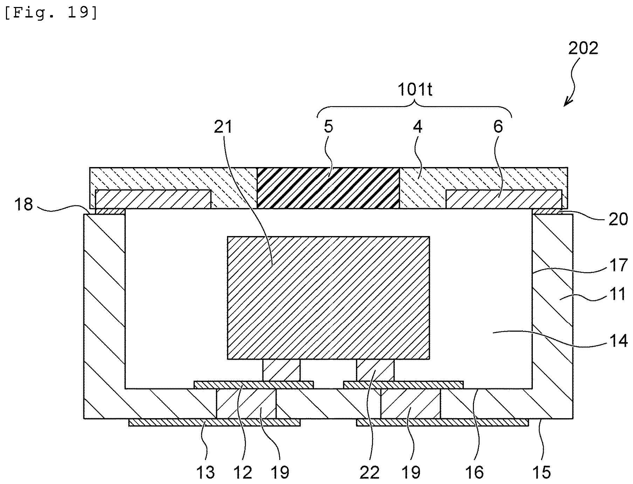

In Modified Example 1, the proportion of the portion constituted of the reflective member 4 on the first surface 1 of the optical member 101a is large, and a larger portion of light from the first surface 1 side can be reflected. For example, in a use as an optical member in a light-emitting device 202 shown in FIG. 19, absorption of light from a light-emitting element 21 can be reduced, a larger portion of the light can be reflected, and the luminance of the light-emitting device 202 can be enhanced.

### Modified Example 2

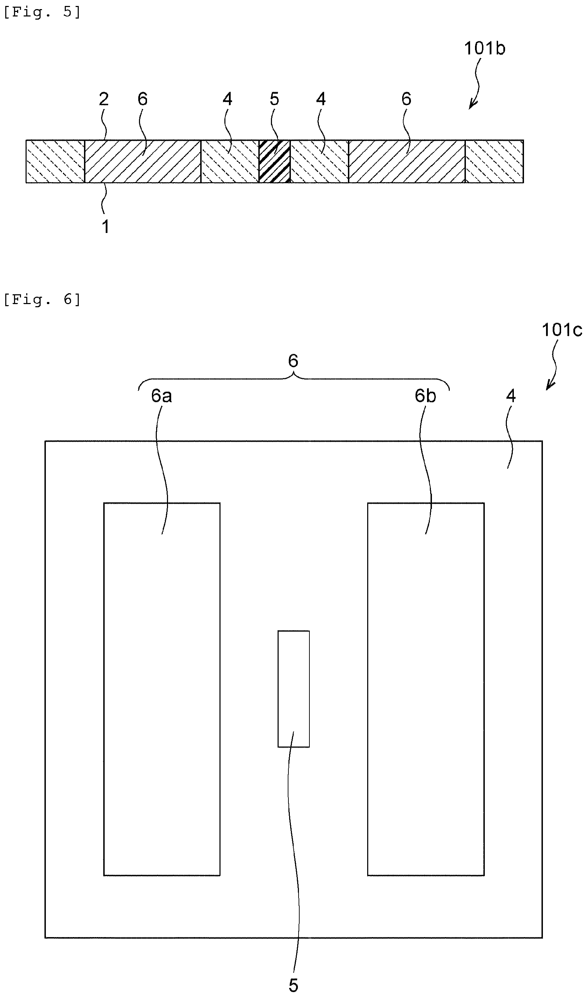

FIG. 5 is a schematic cross-sectional view of an optical member 101b of Modified Example 2. As shown in FIG. 5, in the optical member 101b of Modified Example 2, the heat dissipation members 6 constitute portions of the first surface 1 of the optical member 101b. That is, in the optical member 101b of Modified Example 2, the heat dissipation members 6 are exposed from the reflective member 4 on the first surface 1. The heat dissipation members 6 constitute portions of the second surface 2 of the optical member 101b. That is, in the optical member 101b of Modified Example 2, the heat dissipation members 6 are exposed from the reflective member 4 on the second surface 2.

In Modified Example 2, the heat dissipation members 6 are exposed on the two main surfaces, which are the first surface 1 and the second surface 2, of the optical member 101b, and heat generated in the wavelength conversion member 5 can therefore be more efficiently emitted to the outside.

### Modified Example 3

FIG. 6 is a schematic bottom view of an optical member 101c of Modified Example 3 as viewed from the first surface 1 side. As shown in FIG. 6, in the optical member 101c of Modified Example 3, the heat dissipation members 6 include a first heat dissipation member 6a and a second heat dissipation member 6b, which are a pair of heat dissipation members. The first heat dissipation member 6a and the second heat dissipation member 6b face each other across the wavelength conversion member 5.

In Modified Example 3, the first heat dissipation member 6a and the second heat dissipation member 6b each of which has an elongated rectangular shape as viewed from the first surface 1 side are disposed such that long sides face each other. The length of the long side of the heat dissipation member 6 is greater than the length of the side of the wavelength conversion member 5 facing the long side. With such a constitution, the heat dissipation member 6 can receive a larger portion of the heat generated in the wavelength conversion member 5, and the heat dissipation effect is enhanced.

### Modified Example 4

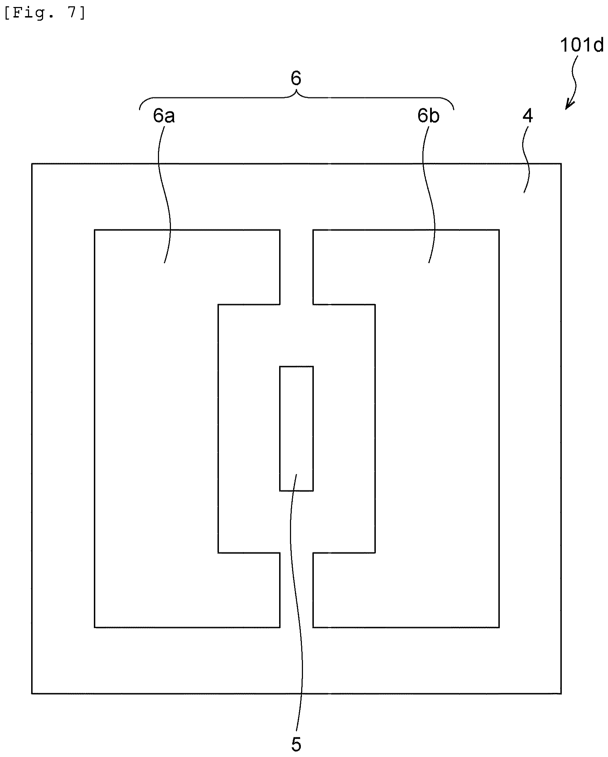

FIG. 7 is a schematic bottom view of an optical member 101d of Modified Example 4 as viewed from the first surface 1 side. As shown in FIG. 7, in the optical member 101d of Modified Example 4, the heat dissipation members 6 include a first heat dissipation member 6a and a second heat dissipation member 6b, which are a pair of heat dissipation members. The first heat dissipation member 6a and the second heat dissipation member 6b face each other across the wavelength conversion member 5.

In Modified Example 4, the first heat dissipation member 6a and the second heat dissipation member 6b each of which has a shape with a recess as viewed from the first surface 1 side surround portions of the wavelength conversion member 5 using these recesses. With such a constitution, the heat dissipation members 6 can receive a larger portion of the heat generated in the wavelength conversion member 5, and the heat dissipation effect is enhanced.

### Modified Example 5

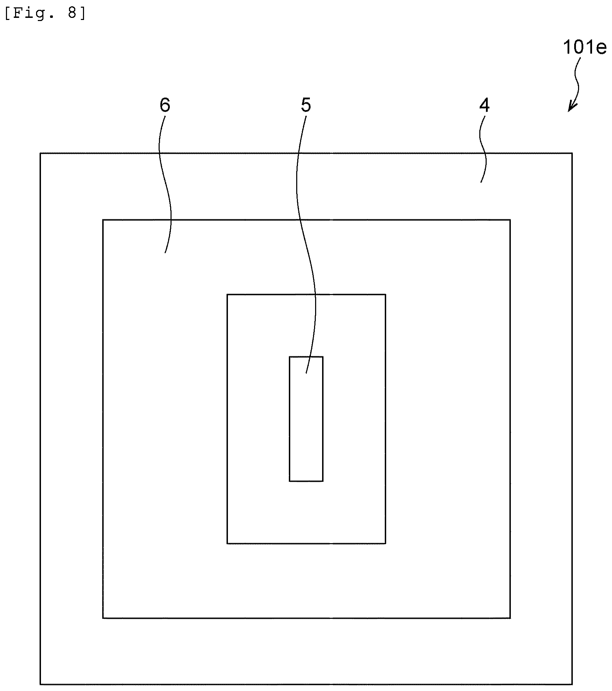

FIG. 8 is a schematic bottom view of an optical member 101e of Modified Example 5 as viewed from the first surface 1 side. As shown in FIG. 8, in the optical member 101e of Modified Example 5, the heat dissipation member 6 surrounds the whole wavelength conversion member 5 as viewed from the first surface 1 side.

Disposing the heat dissipation member 6 so as to surround the whole wavelength conversion member 5 as viewed from the first surface 1 side allows the heat dissipation member 6 to more efficiently receive heat generated in the wavelength conversion member 5, so that the heat dissipation effect is further enhanced.

### Modified Example 6

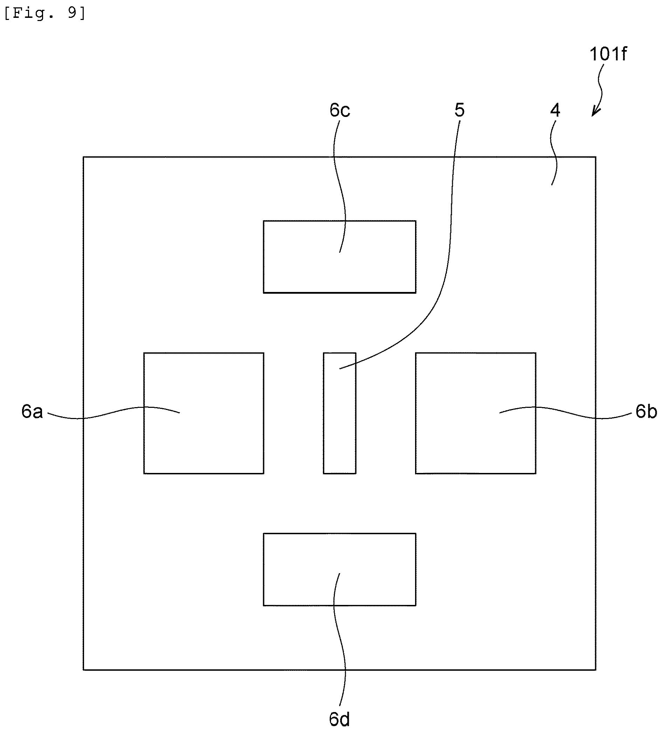

FIG. 9 is a schematic bottom view of an optical member 101f of Modified Example 6 as viewed from the first surface 1 side. As shown in FIG. 9, in the optical member 101f of Modified Example 6, the heat dissipation members 6 include a first heat dissipation member 6a, a second heat dissipation member 6b, a third heat dissipation member 6c, and a fourth heat dissipation member 6d. The first heat dissipation member 6a and the second heat dissipation member 6b are paired and face each other across the wavelength conversion member 5. The third heat dissipation member 6c and the fourth heat dissipation member 6d are paired and face each other across the wavelength conversion member 5.

In Modified Example 6, the heat dissipation members 6 are disposed such that each pair of heat dissipation members is disposed on both sides of the wavelength conversion member 5 and such that every side of the wavelength conversion member 5 faces any of the heat dissipation members as viewed from the first surface 1 side. With such a constitution, the heat dissipation members 6 can receive a larger portion of the heat generated in the wavelength conversion member 5, and the heat dissipation effect is further enhanced.

### Modified Example 7

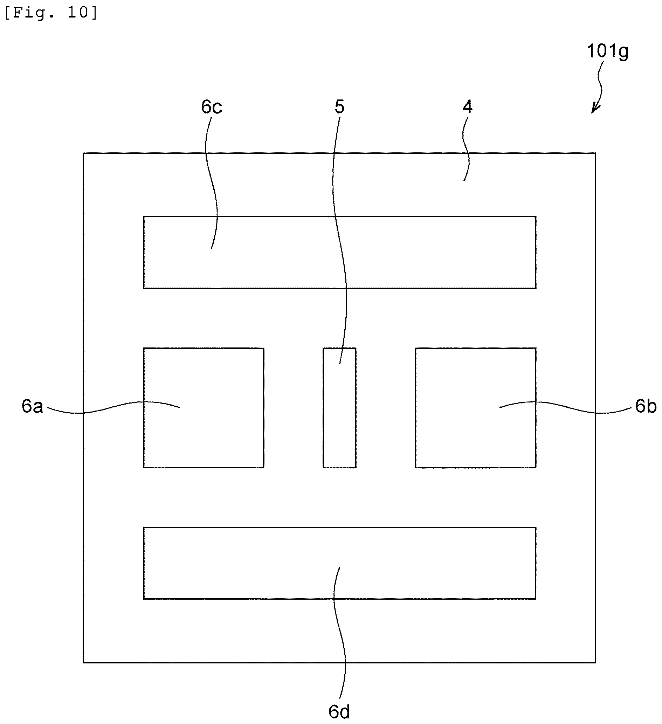

FIG. 10 is a schematic bottom view of an optical member 101g of Modified Example 7 as viewed from the first surface 1 side. As shown in FIG. 10, the optical member 101g of Modified Example 7 is obtained by further increasing the length (length in the lateral direction in the drawing) of the pair of the third heat dissipation member 6c and the fourth heat dissipation member 6d of the optical member 101f of the Modified Example 6. By elongating the heat dissipation members 6 as described above, transfer of heat to the ends of the reflective member 4 is facilitated, so that the heat dissipation effect is enhanced.

### Modified Example 8

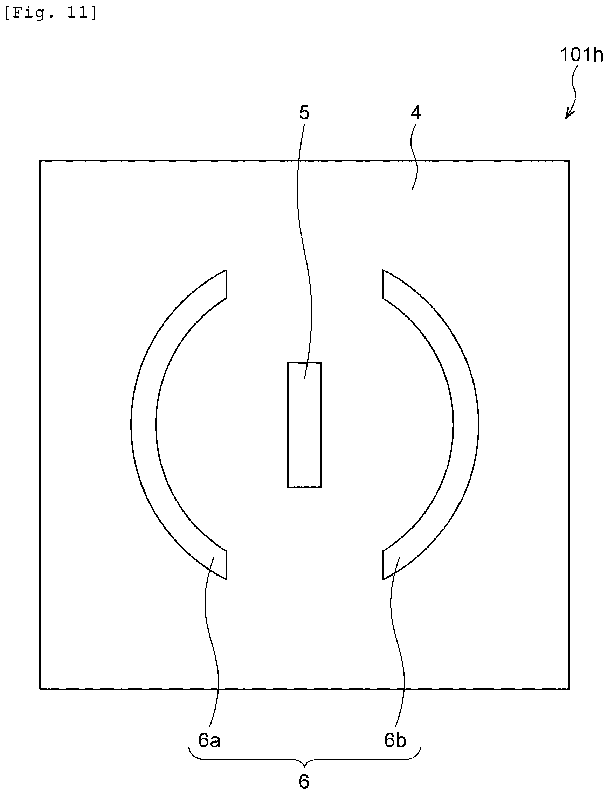

FIG. 11 is a schematic bottom view of an optical member 101h of Modified Example 8 as viewed from the first surface 1 side. As shown in FIG. 11, in the optical member 101h of Modified Example 8, the heat dissipation members 6 include a first heat dissipation member 6a and a second heat dissipation member 6b. The first heat dissipation member 6a and the second heat dissipation member 6b each of which has a circular arc shape as viewed from the first surface 1 side face each other across the wavelength conversion member 5.

With the heat dissipation members 6 having circular arc shapes, variations in distance from the wavelength conversion member 5 in each heat dissipation member depending on the location are reduced, and variations in temperature and heat dissipation effect in the whole optical member can be reduced.

### Modified Example 9

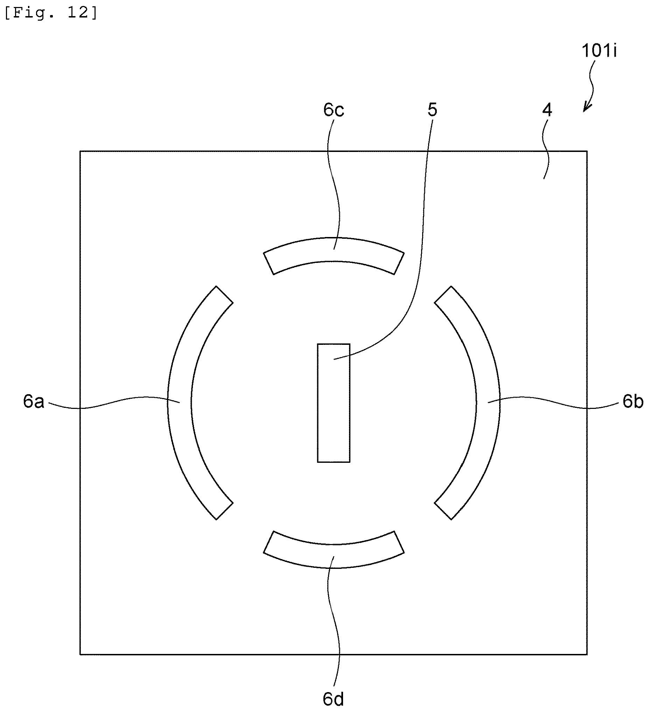

FIG. 12 is a schematic bottom view of an optical member 101i of Modified Example 9 as viewed from the first surface 1 side. As shown in FIG. 12, in the optical member 101i of Modified Example 9, the heat dissipation members 6 include a first heat dissipation member 6a, a second heat dissipation member 6b, a third heat dissipation member 6c, and a fourth heat dissipation member 6d. The first heat dissipation member 6a and the second heat dissipation member 6b are paired and face each other across the wavelength conversion member 5. The third heat dissipation member 6c and the fourth heat dissipation member 6d are paired and face each other across the wavelength conversion member 5. Each of the first heat dissipation member 6a, the second heat dissipation member 6b, the third heat dissipation member 6c, and the fourth heat dissipation member 6d has a circular arc shape as viewed from the first surface 1 side.

In Modified Example 9, the heat dissipation members 6 surround the wavelength conversion member 5 and can receive a larger portion of the heat generated in the wavelength conversion member 5, so that the heat dissipation effect is enhanced.

### Modified Example 10

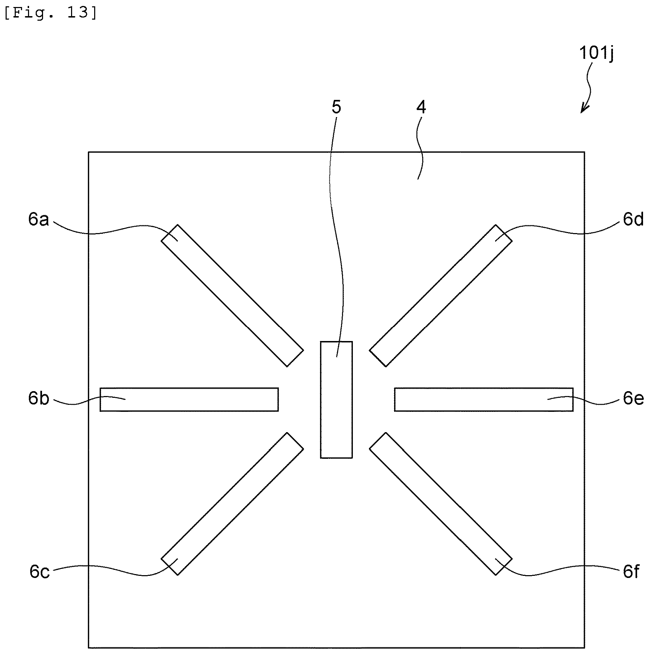

FIG. 13 is a schematic bottom view of an optical member 101j of Modified Example 10 as viewed from the first surface 1 side. As shown in FIG. 13, in the optical member 101j of Modified Example 10, the heat dissipation members 6 include a first heat dissipation member 6a, a second heat dissipation member 6b, a third heat dissipation member 6c, a fourth heat dissipation member 6d, a fifth heat dissipation member 6e, and a sixth heat dissipation member 6f. These heat dissipation members 6a, 6b, 6c, 6d, 6e, and 6f each of which has a bar shape are disposed substantially radially with respect to the wavelength conversion member 5.

The bar-shaped heat dissipation members are preferably disposed substantially evenly with respect to the wavelength conversion member 5. For example, as shown in FIG. 13, the first heat dissipation member 6a, the second heat dissipation member 6b, and the third heat dissipation member 6c constitute a first set, and these three heat dissipation members are radially disposed such that adjacent heat dissipation members form equal angles with respect to the wavelength conversion member 5. Similarly, the fourth heat dissipation member 6d, the fifth heat dissipation member 6e, and the sixth heat dissipation member 6f constitute a second set, and these three heat dissipation members are radially disposed such that adjacent heat dissipation members form equal angles with respect to the wavelength conversion member 5. The first set and the second set are symmetric with the wavelength conversion member 5 therebetween. Disposing the heat dissipation members substantially radially with respect to the wavelength conversion member 5 as described above allows heat generated in the wavelength conversion member 5 to be efficiently transferred to the ends of the reflective member 4, and the heat dissipation effect is further enhanced.

In the optical member 101 according to the first embodiment of the present disclosure, the sizes (such as the widths or lengths) of the heat dissipation members 6 are not particularly limited. The heat dissipation effect is enhanced as the sizes of the heat dissipation members 6 increase, and the light-reflective power of the first surface 1 is enhanced as the sizes decrease.

In the optical member 101 according to the first embodiment of the present disclosure, the heat dissipation members 6 may have recesses or projections at portions in contact with the reflective member 4. The recesses or projections at the portions of the heat dissipation members 6 in contact with the reflective member 4 provide the anchor effect, and the bonding strength between the heat dissipation members 6 and the reflective member 4 is enhanced. The area of the contact surface between the heat dissipation members 6 and the reflective member 4 increases, and heat more easily flows to the heat dissipation members 6.

In the optical member 101 according to the first embodiment of the present disclosure, a portion of the wavelength conversion member 5 exposed from the reflective member 4 may be covered with an anti-reflection layer. With the exposed portion of the wavelength conversion member 5 covered with an anti-reflection film, light from the light-emitting element can be efficiently transmitted.

The anti-reflection layer may cover only the exposed portion of the wavelength conversion member 5 or may cover another portion, such as the reflective member 4, in addition to the exposed portion of the wavelength conversion member 5. For example, the anti-reflection layer covers the first surface 1, the second surface 2, and the lateral surfaces 3 of the optical member 101 except for the exposed portions of the heat dissipation members 6 on the first surface 1. By exposing the heat dissipation members 6 from the anti-reflection layer, the exposed portions can be used as portions to be bonded to another member, and high bonding strength can be obtained.

### Second Embodiment

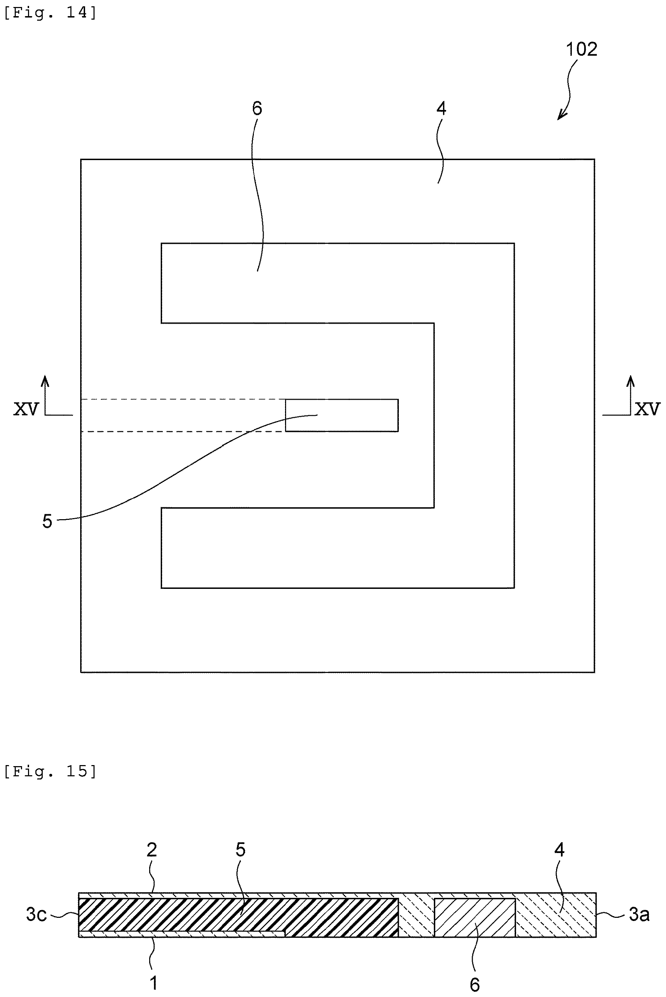

A second embodiment of the present disclosure relates to an optical member 102. The optical member 102 according to the second embodiment of the present disclosure is described referring to FIG. 14 and FIG. 15. FIG. 14 is a schematic bottom view of the optical member 102 as viewed from the first surface 1 side. FIG. 15 is a schematic cross-sectional view of the optical member 102. The schematic cross-sectional view of FIG. 15 shows a cross section of the optical member 102 cut along the line XV-XV of FIG. 14.

As shown in FIG. 14 and FIG. 15, the optical member 102 according to the second embodiment of the present disclosure differs from the optical member 101 of the first embodiment in that the wavelength conversion member 5 constitutes a portion of the first surface 1 and a portion of the third lateral surface 3c of the optical member 102. Further, the optical member 102 according to the second embodiment of the present disclosure differs from the optical member 101 of the first embodiment in that the heat dissipation member 6 surrounds three sides of the wavelength conversion member 5 as viewed from the first surface 1 side.

The wavelength conversion member 5 is disposed in the reflective member 4. The wavelength conversion member 5 constitutes a portion of the first surface 1 and a portion of the third lateral surface 3c of the optical member 102. Specifically, the wavelength conversion member 5 constitutes the first surface 1 of the optical member 102 together with the reflective member 4 and the heat dissipation member 6. The wavelength conversion member 5 also constitutes the third lateral surface 3c of the optical member 102 together with the reflective member 4. In other words, the wavelength conversion member 5 is exposed from the reflective member 4 on the first surface 1 and the third lateral surface 3c. As shown in FIG. 15, the wavelength conversion member 5 has a relatively large thickness in a portion exposed from the first surface 1 and a relatively small thickness in a portion not exposed from the first surface 1.

With the wavelength conversion member 5 having the above structure, light that has entered the wavelength conversion member 5 from the first surface 1 side is emitted from the third lateral surface 3c. In other words, the optical path is bent in the wavelength conversion member 5.

The heat dissipation member 6 is disposed in the reflective member 4 apart from the wavelength conversion member 5. The heat dissipation member 6 constitutes the first surface 1 together with the reflective member 4 and the wavelength conversion member 5. The heat dissipation member 6 surrounds three sides of the wavelength conversion member 5 as viewed from the first surface 1 side.

In the optical member 102 according to the second embodiment of the present disclosure, the optical path in the wavelength conversion member 5 tends to be long, and the amount of heat generated in the wavelength conversion member 5 can be larger. In the optical member in which the amount of heat generated in the wavelength conversion member 5 is large as described above, the heat dissipation effect of the heat dissipation member 6 is more effective.

### Third Embodiment

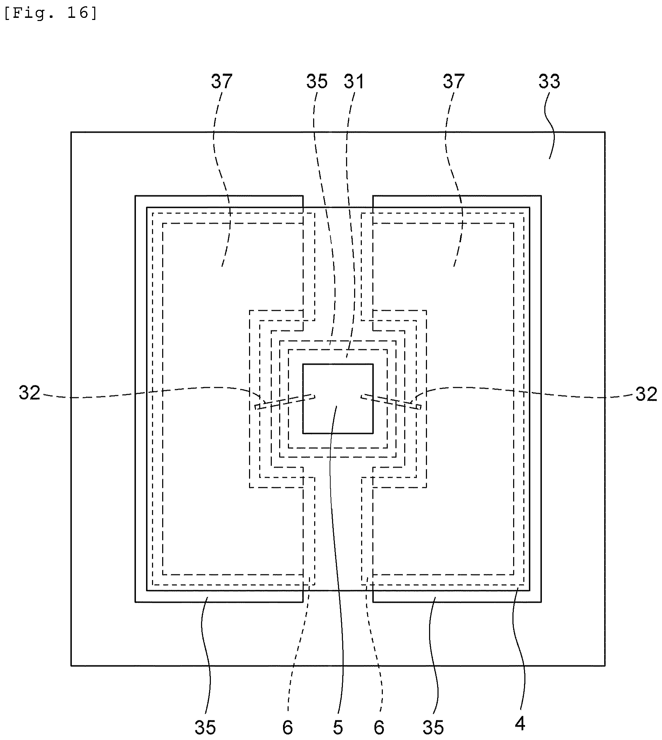

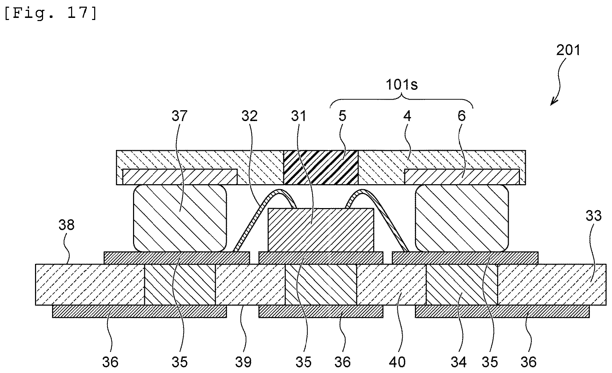

A third embodiment of the present disclosure relates to a light-emitting device 201. The light-emitting device 201 according to the third embodiment of the present disclosure is described referring to FIG. 16 and FIG. 17. FIG. 16 is a schematic plan view of the light-emitting device 201. FIG. 17 is a schematic cross-sectional view of the light-emitting device 201. In the light-emitting device of the present disclosure, a base member 33 side is regarded as the lower side, and an optical member 101s side is regarded as the upper side. That is, the upper side of FIG. 17 is regarded as the upper side, and the lower side is regarded as the lower side.

As shown in FIG. 16 and FIG. 17, the light-emitting device 201 according to the third embodiment of the present disclosure includes:
a base member 33;
a light-emitting element 31 on or above the base member 33; and
an optical member 101s covering the light-emitting element 31 in a plan view.

The base member 33 is a wiring substrate and includes three plate-shaped insulating portions 40, three electroconductive members 34 extending through the insulating portions 40, three wiring layers 35 disposed on a first main surface 38, and three external electrodes 36 disposed on a second main surface 39. The wiring layers 35 and the external electrodes 36 are respectively connected to each other through the electroconductive members 34. One set of the wiring layer 35 and the external electrode 36 connected by the electroconductive member 34 is electrically insulated from the other sets.

The insulating portions 40 are formed of, for example, a resin such as polyimide (PI), polyethylene naphthalate (PEN), and polyethylene terephthalate (PET).

The light-emitting element 31 is disposed on the base member 33, and electrodes of the light-emitting element 31 are electrically connected to the wiring layers 35 of the base member 33 via wires 32.

Metal members 37 are disposed on the wiring layers 35 of the base member 33. The metal members 37 have such a thickness that the upper surfaces of the metal members 37 are located above the upper surface of the light-emitting element 31.

The metal members 37 are preferably formed of a metal material having a high thermal conductivity to enhance the conductivity of heat from the heat dissipation member 6. Examples of the metal material include Cu, Al, Au, Ag, Zn, Ni, and Sn. One type of metal material may be used, or a combination of two or more types may be used.

The metal members 37 may be formed directly on the wiring layers 35, or the metal members 37 that have been separately formed may be bonded to the wiring layers 35.

The metal members 37 can be, for example, plating layers or metal blocks.

The optical member 101s is disposed on the metal members 37 to cover the light-emitting element 31 as viewed from above. The heat dissipation member 6 of the optical member 101s is bonded to the metal members 37.

The heat dissipation member 6 of the optical member 101s is divided into two spaced apart from each other. In other words, the heat dissipation members 6 are insulated from each other. Accordingly, a short circuit between the two heat dissipation members 6 is prevented, so that the heat dissipation members 6 can be directly bonded to the metal members 37.

In the light-emitting device 201, the optical member 101s is bonded to the metal members 37 at the heat dissipation members 6, and sufficient bonding strength can be obtained. In the light-emitting device 201, the heat dissipation members 6 are connected to the metal members 37, the metal members 37 are connected to the wiring layers 35 of the base member 33, the wiring layers 35 are connected to the electroconductive members 34, and the electroconductive members 34 are connected to the external electrodes 36. These members all have high thermal conductivities, the heat generated in the wavelength conversion member 5 is diffused over the entire light-emitting device 201 and more effectively dissipated.

### Fourth Embodiment

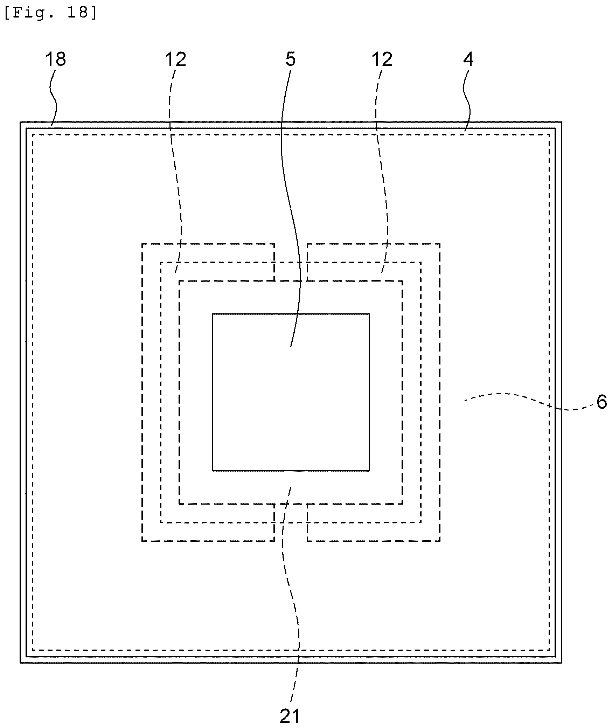

A fourth embodiment of the present disclosure relates to the light-emitting device 202. The light-emitting device 202 according to the fourth embodiment of the present disclosure is described referring to FIG. 18 and FIG. 19. FIG. 18 is a schematic plan view of the light-emitting device 202. FIG. 19 is a schematic cross-sectional view of the light-emitting device 202.

As shown in FIG. 18 and FIG. 19, the light-emitting device 202 according to the fourth embodiment of the present disclosure includes:
a base member 11;
the light-emitting element 21 on or above the base member 11; and
an optical member 101t covering the light-emitting element 21 in a plan view,
in which the base member 11 has a recess 14,
the light-emitting element 21 is disposed on or above a bottom surface 16 defining the recess 14, and
the optical member 101t covers the recess 14.

In the light-emitting device 202, the optical member 101t according to the fourth embodiment of the present disclosure is disposed on an upper surface 18 of a wall portion of the base member 11 with a bonding member 20 therebetween.

In the light-emitting device 202, the heat dissipation member 6 of the optical member 101t is insulated from wiring layers 12 of the base member 11. Accordingly, the optical member 101t in which the heat dissipation member 6 surrounds the whole wavelength conversion member 5 can be used as the optical member, and a higher heat dissipation effect can be obtained.

As the bonding member 20, for example, an adhesive such as solder (such as Au-Sn and Au-In), low-melting-point glass, and a resin (such as a silicone resin and an epoxy resin) can be used.

The base member 11 has the recess 14 defined by the bottom surface 16 and lateral surfaces 17 of the wall portion.

The base member 11 includes the wiring layers 12 and external electrodes 13. As shown in FIG. 18 and FIG. 19, the wiring layers 12 are disposed on the bottom surface 16 of the recess and electrically connected to electrodes 22 of the light-emitting element 21. The external electrodes 13 are disposed on a lower surface 15 of the base member. The wiring layers 12 are electrically connected to the external electrodes 13 via electroconductive members 19 extending through the bottom portion of the base member.

The base material of the base member 11 can be formed of, for example, a single material of an insulating material such as glass, a ceramic, a resin, wood, and pulp, a semiconductor, or an electroconductive material such as a metal (such as copper, silver, gold, and aluminum) or a composite material thereof. The material for the base material is preferably a metal, a ceramic, or the like, more preferably a ceramic, which is an inorganic material. Examples of the ceramic include alumina, aluminum nitride, silicon nitride, and mullite. The ceramic can be preferably aluminum nitride having high heat dissipation performance.

The light-emitting element 21 includes a substrate and a semiconductor layer. The substrate can be a crystal growth substrate on which a semiconductor crystal constituting the semiconductor layer can grow. The substrate is, for example, a sapphire substrate or a gallium nitride substrate. The semiconductor layer includes, for example, an n-type semiconductor layer, a p-type semiconductor layer, and a light-emitting layer disposed between the n-type semiconductor layer and the p-type semiconductor layer.

The light-emitting element 21 includes a pair of electrodes 22 electrically connected respectively to the wiring layers 12. The pair of electrodes 22 are what is called a p-electrode and an n-electrode.

The semiconductor layer may be of a double heterojunction. The light-emitting layer may have a structure such as the single quantum well (SQW) or a structure having a plurality of well layers, such as the multiple quantum well (MQW). The semiconductor layer is configured to be capable of emitting visible light or ultraviolet light. Such a semiconductor layer including the light-emitting layer can include, for example, InₓAl_{y}Ga_{1-x-y}N (0 ≤ x, 0 ≤ y, and x + y ≤ 1). The peak wavelength of light emitted from the semiconductor layer falls within the range of, for example, 260 nm or more and 630 nm or less.

The semiconductor layer may include one light-emitting layer or a plurality of light-emitting layers. The semiconductor layer including a plurality of light-emitting layers may have a structure including a plurality of light-emitting layers between one n-type semiconductor layer and one p-type semiconductor layer or may have a repetitive structure including the n-type semiconductor layer, the light-emitting layer, and the p-type semiconductor layer in order. When the semiconductor layer includes a plurality of light-emitting layers, the semiconductor layer may include light-emitting layers with different peak emission wavelengths or light-emitting layers with the same peak emission wavelength. The term "same peak emission wavelength" includes the case in which there are variations of approximately several nanometers. The combination of the peak emission wavelengths of a plurality of light-emitting layers can be appropriately selected. In the case in which the semiconductor layer includes two light-emitting layers, the combination of light-emitting layers that emit blue light and blue light, green light and green light, red light and red light, ultraviolet light and ultraviolet light, blue light and green light, blue light and red light, or green light and red light can be selected. Each light-emitting layer may include a plurality of active layers having different peak emission wavelengths or a plurality of active layers having the same peak emission wavelength.

The light-emitting element 21 can be a light-emitting diode or a laser diode.

## Claims

1. An optical member (101) having a first surface (1), a second surface (2) opposite to the first surface (1), and a lateral surface (3) between the first surface (1) and the second surface (2), the optical member (101) comprising:
a reflective member (4) containing a light-reflective material (7) and an inorganic binder (8), wherein the inorganic binder (8) contains silica and an alkali metal;
a wavelength conversion member (5) disposed in the reflective member (4); and
at least one heat dissipation member (6) disposed in the reflective member (4) apart from the wavelength conversion member (5).

2. The optical member (101) according to claim 1, wherein the wavelength conversion member (5) constitutes a portion of the first surface (1) of the optical member (101), and a portion of the second surface (2) or a portion of the lateral surface (3) of the optical member (101).

3. The optical member (101) according to claim 1, wherein the wavelength conversion member (5) constitutes a portion of the first surface (1) and a portion of the second surface (2) of the optical member (101).

4. The optical member (101) according to claim 1, wherein the heat dissipation member (6) surrounds at least a portion of the wavelength conversion member (5) as viewed from a first surface side of the optical member (101).

5. The optical member (101) according to claim 1,
wherein the at least one heat dissipation member (6) comprises a pair of heat dissipation members, and
wherein the pair of heat dissipation members face each other across the wavelength conversion member (5) as viewed from a first surface side of the optical member (101).

6. The optical member (101) according to claim 1, wherein the heat dissipation member (6) comprises a portion having a circular arc shape as viewed from a first surface side of the optical member (101).

7. The optical member (101) according to claim 1, wherein the heat dissipation member (6) comprises a portion substantially radially disposed with respect to the wavelength conversion member (5) as viewed from a first surface side of the optical member (101).

8. The optical member (101) according to claim 1, wherein the heat dissipation member (6) constitutes a portion of the first surface (1) of the optical member (101).

9. The optical member (101) according to claim 1, wherein the heat dissipation member (6) constitutes at least a portion of the lateral surface (3) of the optical member (101).

10. The optical member (101) according to claim 1, wherein the heat dissipation member (6) constitutes at least a portion of the second surface (2) of the optical member (101).

11. The optical member (101) according to claim 1,
wherein the optical member (101) has a substantially rectangular parallelepiped shape,
wherein the wavelength conversion member (5) is disposed in the reflective member (4) so as to be exposed on the first surface (1) and the second surface (2) and located at a central portion of the reflective member (4) in a plan view, and
wherein the heat dissipation member (6) is disposed in the reflective member (4) so as to be exposed on the first surface (1) and the lateral surface (3) and located around the wavelength conversion member (5).

12. The optical member (101) according to claim 1, wherein the wavelength conversion member (5) contains a phosphor.

13. The optical member (101) according to claim 1, wherein the wavelength conversion member (5) contains a red phosphor.

14. The optical member (101) according to claim 1, wherein the wavelength conversion member (5) is a layered body comprising a plurality of layers containing at least one phosphor.

15. The optical member (101) according to claim 1, wherein the heat dissipation member (6) contains a metal member.

16. The optical member (101) according to claim 15, wherein the metal member contains Cu, Ag, Pt, Ni, Al, Pd, Au, Fe, Co, W, Mo, or an alloy thereof.

17. The optical member (101) according to claim 1, wherein the light-reflective material (7) contains boron nitride or alumina.

18. The optical member (101) according to claim 1, wherein an average particle diameter of the light-reflective material (7) is 0.6 µm or more and 43 µm or less.

19. The optical member (101) according to claim 1, wherein an average aspect ratio of the light-reflective material (7) is 10 or more, wherein the average aspect ratio of the light-reflective material (7) is calculated by measuring the thickness and the width of the light-reflective material (7) in a cross-section of the reflective member (4).

20. The optical member (101) according to claim 19, wherein the alkali metal contains potassium or sodium.

21. The optical member (101) according to claim 1, wherein the reflective member (4) contains a light-scattering material.

22. The optical member (101) according to claim 21, wherein the light-scattering material contains zirconia or titania.

23. The optical member (101) according to claim 1, wherein a portion of the wavelength conversion member (5) exposed from the reflective member (4) is covered with an anti-reflection layer.

24. The optical member (101) according to claim 1,
wherein at least a portion of the heat dissipation member (6) is exposed at least on the first surface (1), and
wherein the first surface (1), the second surface (2), and the lateral surface (3) of the optical member (101) are covered with an anti-reflection layer except for the portion of the heat dissipation member (6) exposed on the first surface (1).

25. A light-emitting device (202) comprising:
a base member (11);
a light-emitting element (21) on the base member (11); and
the optical member (101) according to claim 1 covering the light-emitting element (21) in a plan view.

26. The light-emitting device (202) according to claim 25,
wherein the base member (11) has a recess (14),
wherein the light-emitting element (21) is disposed on a bottom surface (16) defining the recess (14), and
wherein the optical member (101) covers the recess (14).

27. The light-emitting device (202) according to claim 25,
wherein at least a portion of the heat dissipation member (6) is exposed on the first surface (1) of the optical member (101), and
wherein the portion of the heat dissipation member (6) exposed on the first surface (1) is bonded to the base member (11).

## Patentansprüche

1. Optisches Element (101), das eine erste Oberfläche (1), eine der ersten Oberfläche (1) gegenüberliegende zweite Oberfläche (2) und eine Seitenoberfläche (3) zwischen der ersten Oberfläche (1) und der zweiten Oberfläche (2) hat, das optische Element (101) aufweisend:
ein reflektierendes Element (4), enthaltend ein lichtreflektierendes Material (7) und ein anorganisches Bindemittel (8), wobei das anorganische Bindemittel (8) Siliciumdioxid und ein Alkalimetall enthält;
ein in dem reflektierenden Element (4) angeordnetes Wellenlängenumwandlungselement (5); und
mindestens ein Wärmeableitungselement (6), das getrennt von dem Wellenlängenumwandlungselement (5) in dem reflektierenden Element (4) angeordnet ist.

2. Optisches Element (101) nach Anspruch 1, wobei das Wellenlängenumwandlungselement (5) einen Abschnitt der ersten Oberfläche (1) des optischen Elements (101) und einen Abschnitt der zweiten Oberfläche (2) oder einen Abschnitt der Seitenoberfläche (3) des optischen Elements (101) bildet.

3. Optisches Element (101) nach Anspruch 1, wobei das Wellenlängenumwandlungselement (5) einen Abschnitt der ersten Oberfläche (1) und einen Abschnitt der zweiten Oberfläche (2) des optischen Elements (101) bildet.

4. Optisches Element (101) nach Anspruch 1, wobei das Wärmeableitungselement (6) mindestens einen Abschnitt des Wellenlängenumwandlungselements (5) bei Betrachtung von einer ersten Oberflächenseite des optischen Elements (101) umgibt.

5. Optisches Element (101) nach Anspruch 1,
wobei das mindestens eine Wärmeableitungselement (6) ein Paar von Wärmeableitungselementen aufweist, und
wobei das Paar von Wärmeableitungselementen bei Betrachtung von einer ersten Oberflächenseite des optischen Elements (101) einander über das Wellenlängenumwandlungselement (5) hinweg zugewandt ist.

6. Optisches Element (101) nach Anspruch 1, wobei das Wärmeableitungselement (6) einen Abschnitt aufweist, der bei Betrachtung von einer ersten Oberflächenseite des optischen Elements (101) eine Kreisbogenform hat.

7. Optisches Element (101) nach Anspruch 1, wobei das Wärmeableitungselement (6) einen Abschnitt aufweist, der bei Betrachtung von einer ersten Oberflächenseite des optischen Elements (101) im Wesentlichen radial in Bezug auf das Wellenlängenumwandlungselement (5) angeordnet ist.

8. Optisches Element (101) nach Anspruch 1, wobei das Wärmeableitungselement (6) einen Abschnitt der ersten Oberfläche (1) des optischen Elements (101) bildet.

9. Optisches Element (101) nach Anspruch 1, wobei das Wärmeableitungselement (6) mindestens einen Abschnitt der Seitenoberfläche (3) des optischen Elements (101) bildet.

10. Optisches Element (101) nach Anspruch 1, wobei das Wärmeableitungselement (6) mindestens einen Abschnitt der zweiten Oberfläche (2) des optischen Elements (101) bildet.

11. Optisches Element (101) nach Anspruch 1,
wobei das optische Element (101) eine im Wesentlichen rechteckige Parallelepipedform hat,
wobei das Wellenlängenumwandlungselement (5) in dem reflektierenden Element (4) angeordnet ist, um an der ersten Oberfläche (1) und der zweiten Oberfläche (2) freizuliegen und sich in einer Draufsicht an einem zentralen Abschnitt des reflektierenden Elements (4) zu befinden, und
wobei das Wärmeableitungselement (6) in dem reflektierenden Element (4) angeordnet ist, um an der ersten Oberfläche (1) und der Seitenoberfläche (3) freizuliegen und um das Wellenlängenumwandlungselement (5) herum befindlich zu sein.

12. Optisches Element (101) nach Anspruch 1, wobei das Wellenlängenumwandlungselement (5) einen Phosphor enthält.

13. Optisches Element (101) nach Anspruch 1, wobei das Wellenlängenumwandlungselement (5) einen roten Phosphor enthält.

14. Optisches Element (101) nach Anspruch 1, wobei das Wellenlängenumwandlungselement (5) ein Schichtkörper ist, der mehrere Schichten aufweist, die mindestens einen Phosphor enthalten.

15. Optisches Element (101) nach Anspruch 1, wobei das Wärmeableitungselement (6) ein Metallelement enthält.

16. Optisches Element (101) nach Anspruch 15, wobei das Metallelement Cu, Ag, Pt, Ni, Al, Pd, Au, Fe, Co, W, Mo oder eine Legierung davon enthält.

17. Optisches Element (101) nach Anspruch 1, wobei das lichtreflektierende Material (7) Bornitrid oder Tonerde enthält.

18. Optisches Element (101) nach Anspruch 1, wobei ein durchschnittlicher Teilchendurchmesser des lichtreflektierenden Materials (7) 0,6 µm oder mehr und 43 µm oder weniger beträgt.

19. Optisches Element (101) nach Anspruch 1, wobei ein durchschnittliches Aspektverhältnis des lichtreflektierenden Materials (7) 10 oder mehr beträgt, wobei das durchschnittliche Aspektverhältnis des lichtreflektierenden Materials (7) durch Messen der Dicke und der Breite des lichtreflektierenden Materials (7) in einem Querschnitt des reflektierenden Elements (4) berechnet wird.

20. Optisches Element (101) nach Anspruch 19, wobei das Alkalimetall Kalium oder Natrium enthält.

21. Optisches Element (101) nach Anspruch 1, wobei das reflektierende Element (4) ein lichtstreuendes Material enthält.

22. Optisches Element (101) nach Anspruch 21, wobei das lichtstreuende Material Zirkonoxid oder Titandioxid enthält.

23. Optisches Element (101) nach Anspruch 1, wobei ein Abschnitt des Wellenlängenumwandlungselements (5), der von dem reflektierenden Element (4) freiliegt, mit einer Antireflexionsschicht bedeckt ist.

24. Optisches Element (101) nach Anspruch 1,
wobei mindestens ein Abschnitt des Wärmeableitungselements (6) mindestens an der ersten Oberfläche (1) freiliegt, und
wobei die erste Oberfläche (1), die zweite Oberfläche (2) und die Seitenoberfläche (3) des optischen Elements (101) mit einer Antireflexionsschicht bedeckt sind, mit Ausnahme des Abschnitts des Wärmeableitungselements (6), der an der ersten Oberfläche (1) freiliegt.

25. Lichtemittierende Vorrichtung (202), aufweisend:
ein Basiselement (11);
ein lichtemittierendes Bauteil (21) auf dem Basiselement (11); und
das optische Element (101) nach Anspruch 1, das das lichtemittierende Bauteil (21) in einer Draufsicht bedeckt.

26. Lichtemittierende Vorrichtung (202) nach Anspruch 25,
wobei das Basiselement (11) eine Aussparung (14) hat,
wobei das lichtemittierende Bauteil (21) auf einer Bodenoberfläche (16) angeordnet ist, die die Aussparung (14) definiert, und
wobei das optische Element (101) die Aussparung (14) bedeckt.

27. Lichtemittierende Vorrichtung (202) nach Anspruch 25,
wobei mindestens ein Abschnitt des Wärmeableitungselements (6) auf der ersten Oberfläche (1) des optischen Elements (101) freiliegt, und
wobei der auf der ersten Oberfläche (1) freiliegende Abschnitt des Wärmeableitungselements (6) mit dem Basiselement (11) verbunden ist.

## Revendications

1. Élément optique (101) ayant une première surface (1), une seconde surface (2) opposée à la première surface (1), et une surface latérale (3) entre la première surface (1) et la seconde surface (2), l'élément optique (101) comprenant :
un élément réfléchissant (4) contenant un matériau réfléchissant la lumière (7) et un liant inorganique (8), dans lequel le liant inorganique (8) contient de la silice et un métal alcalin ;
un élément de conversion de longueur d'onde (5) disposé dans l'élément réfléchissant (4) ; et
au moins un élément de dissipation thermique (6) disposé dans l'élément réfléchissant (4) à l'écart de l'élément de conversion de longueur d'onde (5).

2. Élément optique (101) selon la revendication 1, dans lequel l'élément de conversion de longueur d'onde (5) constitue une partie de la première surface (1) de l'élément optique (101), et une partie de la seconde surface (2) ou une partie de la surface latérale (3) de l'élément optique (101).

3. Élément optique (101) selon la revendication 1, dans lequel l'élément de conversion de longueur d'onde (5) constitue une partie de la première surface (1) et une partie de la seconde surface (2) de l'élément optique (101).

4. Élément optique (101) selon la revendication 1, dans lequel l'élément de dissipation thermique (6) entoure au moins une partie de l'élément de conversion de longueur d'onde (5) tel que vu depuis un côté de la première surface de l'élément optique (101).

5. Élément optique (101) selon la revendication 1,
dans lequel l'au moins un élément de dissipation thermique (6) comprend une paire d'éléments de dissipation thermique, et
dans lequel la paire d'éléments de dissipation thermique se fait face de part et d'autre de l'élément de conversion de longueur d'onde (5) tel que vu depuis un côté de la première surface de l'élément optique (101).

6. Élément optique (101) selon la revendication 1, dans lequel l'élément de dissipation thermique (6) comprend une partie ayant une forme d'arc circulaire tel que vu depuis un côté de la première surface de l'élément optique (101).

7. Élément optique (101) selon la revendication 1, dans lequel l'élément de dissipation thermique (6) comprend une partie disposée sensiblement radialement par rapport à l'élément de conversion de longueur d'onde (5) tel que vu depuis un côté de la première surface de l'élément optique (101).

8. Élément optique (101) selon la revendication 1, dans lequel l'élément de dissipation thermique (6) constitue une partie de la première surface (1) de l'élément optique (101).

9. Élément optique (101) selon la revendication 1, dans lequel l'élément de dissipation thermique (6) constitue au moins une partie de la surface latérale (3) de l'élément optique (101).

10. Élément optique (101) selon la revendication 1, dans lequel l'élément de dissipation thermique (6) constitue au moins une partie de la seconde surface (2) de l'élément optique (101).

11. Élément optique (101) selon la revendication 1,
dans lequel l'élément optique (101) a une forme sensiblement de parallélépipède rectangle,
dans lequel l'élément de conversion de longueur d'onde (5) est disposé dans l'élément réfléchissant (4) de manière à être exposé sur la première surface (1) et la seconde surface (2) et situé au niveau d'une partie centrale de l'élément réfléchissant (4) dans une vue en plan, et
dans lequel l'élément de dissipation thermique (6) est disposé dans l'élément réfléchissant (4) de manière à être exposé sur la première surface (1) et la surface latérale (3) et situé autour de l'élément de conversion de longueur d'onde (5).

12. Élément optique (101) selon la revendication 1, dans lequel l'élément de conversion de longueur d'onde (5) contient un luminophore.

13. Élément optique (101) selon la revendication 1, dans lequel l'élément de conversion de longueur d'onde (5) contient un luminophore rouge.

14. Élément optique (101) selon la revendication 1, dans lequel l'élément de conversion de longueur d'onde (5) est un corps stratifié comprenant une pluralité de couches contenant au moins un luminophore.

15. Élément optique (101) selon la revendication 1, dans lequel l'élément de dissipation thermique (6) contient un élément métallique.

16. Élément optique (101) selon la revendication 15, dans lequel l'élément métallique contient Cu, Ag, Pt, Ni, AI, Pd, Au, Fe, Co, W, Mo, ou un alliage de ceux-ci.

17. Élément optique (101) selon la revendication 1, dans lequel le matériau réfléchissant la lumière (7) contient du nitrure de bore ou de l'alumine.

18. Élément optique (101) selon la revendication 1, dans lequel le diamètre moyen de particules du matériau réfléchissant la lumière (7) est de 0,6 µm ou plus et de 43 µm ou moins.

19. Élément optique (101) selon la revendication 1, dans lequel un rapport de forme moyen du matériau réfléchissant la lumière (7) est de 10 ou plus, dans lequel le rapport de forme moyen du matériau réfléchissant la lumière (7) est calculé en mesurant l'épaisseur et la largeur du matériau réfléchissant la lumière (7) dans une section transversale de l'élément réfléchissant (4).

20. Élément optique (101) selon la revendication 19, dans lequel le métal alcalin contient du potassium ou du sodium.

21. Élément optique (101) selon la revendication 1, dans lequel l'élément réfléchissant (4) contient un matériau de diffusion de lumière.

22. Élément optique (101) selon la revendication 21, dans lequel le matériau de diffusion de lumière contient de la zircone ou du dioxyde de titane.

23. Élément optique (101) selon la revendication 1, dans lequel une partie de l'élément de conversion de longueur d'onde (5) exposée depuis l'élément réfléchissant (4) est recouverte d'une couche antireflet.

24. Élément optique (101) selon la revendication 1,
dans lequel au moins une partie de l'élément de dissipation thermique (6) est exposée au moins sur la première surface (1), et
dans lequel la première surface (1), la seconde surface (2) et la surface latérale (3) de l'élément optique (101) sont recouvertes d'une couche antireflet à l'exception de la partie de l'élément de dissipation thermique (6) exposée sur la première surface (1).

25. Dispositif électroluminescent (202) comprenant :
un élément de base (11) ;
un élément électroluminescent (21) sur l'élément de base (11) ; et
l'élément optique (101) selon la revendication 1 recouvrant l'élément électroluminescent (21) dans une vue en plan.

26. Dispositif électroluminescent (202) selon la revendication 25,
dans lequel l'élément de base (11) présente un évidement (14),
dans lequel l'élément électroluminescent (21) est disposé sur une surface de fond (16) définissant l'évidement (14), et
dans lequel l'élément optique (101) recouvre l'évidement (14).

27. Dispositif électroluminescent (202) selon la revendication 25,
dans lequel au moins une partie de l'élément de dissipation thermique (6) est exposée sur la première surface (1) de l'élément optique (101), et
dans lequel la partie de l'élément de dissipation thermique (6) exposée sur la première surface (1) est liée à l'élément de base (11).
